# EUROPÄISCHE PATENTSCHRIFT

(11) **EP 0 631 832 B1**
(45) Veröffentlichungstag und Bekanntmachung des Hinweises auf die Patenterteilung: **20.05.1998**
(21) Anmeldenummer: 93110556.3
(22) Anmeldetag: 02.07.1993
(51) Int. Cl.: B22D 27/04, C30B 11/00

(54) **Verfahren zum gerichteten Erstarren einer Metallschmelze und Giessvorrichtung zu seiner Durchführung**
Method and apparatus for directional solidification of a metal melt
Procédé et dispositif pour la coulée par solidification dirigée de métal en fusion

(43) Veröffentlichungstag der Anmeldung: 04.01.1995
(73) Patentinhaber: ALD Vacuum Technologies GmbH, 63526 Erlensee (DE)
(72) Erfinder: Hugo, Franz, D-8750 Aschaffenburg (DE)
(74) Vertreter: Schlagwein, Udo, Dipl.-Ing.

(56) Entgegenhaltungen:
- EP-A- 0 010 538
- FR-A- 2 021 728
- FR-A- 2 152 649
- US-A- 4 108 236
- US-A- 4 540 550

## Beschreibung

Die Erfindung betrifft ein Verfahren zum gerichteten Erstarren einer in eine Gießform gegossenen Metallschmelze, beispielsweise Nickel, durch Herausbewegen der Gießform aus einer Heizkammer und Eintauchen der Gießform in ein als Kühlschmelze dienendes Flüssigmetallbad niedrigeren Schmelzpunktes als die Metallschmelze in der Gießform, beispielsweise Aluminium. Weiterhin betrifft die Erfindung eine Gießvorrichtung zur Durchführung dieses Verfahrens.

Ein solches Verfahren und solche Gießvorrichtungen sind Gegenstand der DE-A-28 15 818. Das Eintauchen der Gießform in die Kühlschmelze dient dazu, durch einen intensiven, axialen Wärmefluß beim Erstarren des Gußteiles in der Gießform eine Fest-Flüssig-Zone möglichst geringer Höhe und eine möglichst ebene, quer zur Haupterstrekkungsrichtung des Gußteiles verlaufende Phasengrenze zwischen fest und flüssig zu erreichen, damit die Kristalle axial in das Gußstück hineinwachsen. Diese Zielrichtung erfordert es, die radiale Abstrahlung von Wärme oberhalb der Kühlschmelze möglichst gering zu halten. Hierzu ist bei der bekannten Gießvorrichtung an der Unterseite der Heizkammer ein zur Gießform hin gerichteter, allgemein als Baffle bezeichneter Strahlungsschirm vorgesehen. Zusätzlich schwimmt auf der Kühlschmelze eine Trennplatte aus einem wärmeisolierenden Material, welche zum Eintauchen der Gießform in die Kühlschmelze eine Öffnung hat. Die Wärmedämmung ist jedoch nur unvollkommen, insbesondere dann, wenn die Gußteile mehrere nach unten gerichtete Teile aufweisen, da dann der Strahlungsschirm und die Trennplatte die Bereiche zwischen diesen Teilen nicht erreichen können. Hiervon abgesehen, verbleibt zwangsläufig zwischen der Gießform und dem Strahlungsschirm sowie der Gießform und der Trennplatte ein Spalt, durch den Wärme abgestrahlt wird.

Die DE-B-19 53 716 zeigt auch schon zum Eintauchen einer Gießform mit einer abzukühlenden Metallschmelze einen Behälter mit einer Kühlschmelze, dessen Oberfläche durch eine wärmeisolierende Schicht abgedeckt ist. Diese Schicht hat den Sinn, ein Oxidieren oder ein übermäßig starkes Abkühlen der Kühlschmelze zu verhindern. Die Gießform durchdringt beim Eintauchen in die Kühlschmelze diese wärmeisolierende Schicht. Sie wird allerdings nicht aus einer Heizkammer herausbewegt.

Durch die DE-B-22 42 111 ist es bei einem gattungsgemäßen Verfahren bekannt, die Oberfläche der Kühlschmelze so dicht unterhalb der Heizkammer vorzusehen, daß die Kühlplatte der Gießform vor dem Eintauchen der Gießform zumindest teilweise in die Kühlschmelze eintaucht. Hierdurch ist die Kühlplatte schon beim Füllen der Gießform durch die Kühlschmelze gekühlt, so daß sie eine besonders gute Kühlwirkung ausübt. Zur Vermeidung von Wärmeverlusten zwischen dem unteren Ende der Heizkammer und der Gießform ist bei der Vorrichtung nach der DE-B-22 42 111 ein Hitzeschild vorgesehen.

Der Erfindung liegt das Problem zugrunde, ein Verfahren der eingangs genannten Art derart weiterzuentwickeln, daß sich bei der Erstarrung der Gußteile ein möglichst steiler Temperaturgradient bei einem möglichst geringen radialen Wärmefluß erreichen läßt. Weiterhin soll eine Gießvorrichtung zur Durchführung dieses Verfahrens geschaffen werden.

Das erstgenannte Problem wird erfindungsgemäß dadurch gelöst, daß zur Abdichtung zwischen der Heizkammer und der Gießform auf der Kühlschmelze eine schwimmende, aus einem fließfähigen Material bestehende Wärmeisolationsschicht aufgegeben und bevor die Gießform die Wärmeisolationsschicht durchdringt und in die Kühlschmelze eintaucht die Heizkammer oder die Kühlschmelze so weit verfahren wird, daß die Heizkammer die Wärmeisolationsschicht berührt oder in sie eintaucht.

Durch eine solche schwimmende Wärmeisolationsschicht, welche bis gegen die Heizkammer reicht, ergibt sich eine optische Trennung zwischen der Heizkammer und der Kühlschmelze, so daß die Wärmeverluste in radialer Richtung vernachlässigbar gering sind und auf den bisher erforderlichen, kostenintensiven Hitzeschild in diesem Bereich verzichtet werden kann. Dank dem erfindungsgemäßen Verfahren ergibt sich aufgrund der allseitigen und vollkommenen Abdichtung ein optimaler axialer Wärmefluß vom Gußteil in die Kühlschmelze hinein. Dadurch wird eine Verbesserung der metallurgischen Eigenschaften der Gußteile erreicht. Weiterhin können Gußteile mit komplizierter Form oder mehrere Gußteile gleichzeitig gegossen und anschließend erstarrt werden, weil die Wärmeisolationsschicht stets der Kontur der Gießform folgt und immer dichtend gegen sie anliegt. Auch ergibt sich infolge der Wärmeisolationsschicht eine höhere Produktivität, weil die Erstarrung schneller als beim Stand der Technik erfolgen kann.

Die Wärmeisolationsschicht kann mit üblichen Mitteln sehr kostengünstig erzeugt werden, wenn zu ihrer Bildung Festkörper mit einer von der Kühlschmelze nicht benetzbaren Oberfläche verwendet werden.

Trotz einer guten Wärmeisolationswirkung besonders kostengünstig kann die Wärmeisolationsschicht gebildet werden, wenn für sie ein Granulat aus Graphit, Keramik oder Aluminiumoxid mit einer eine Benetzung ausschließenden Beschichtung verwendet wird.

Die Beschichtung besteht vorzugsweise aus Bornitrit. Alternativ ist es jedoch auch möglich, unbeschichtete Festkörper aus Bornitrit oder Kugeln aus SiAlO₂N zu verwenden.

Das erfindungsgemäße Verfahren kann auf sehr einfache Weise unterschiedlichen Anforderungen angepaßt werden, wenn zur Beeinflussung der metallurgischen Eigenschaften der Gußstücke die Dicke der Wärmeisolationsschicht verändert wird.

Wegen der infolge der optischen Trennung geringen Wärmeverluste und damit guten Kühlwirkung kann gemäß einer anderen Weiterbildung des Verfahrens eine Gießform ohne Kühlplatte verwendet werden.

Das zweitgenannte Problem, nämlich die Schaffung einer Gießvorrichtung zur Durchführung des Verfahrens, wird erfindungsgemäß dadurch gelöst, daß die Wärmedämmung eine auf der Kühlschmelze schwimmende Wärmeisolationsschicht aus einem fließfähigen Material ist, welche zumindest bis zur Unterkante der Heizkammer ragt.

Eine solche Gießvorrichtung ist einfacher aufgebaut als die bisher bekannten Gießvorrichtungen, weil sie keine aufwendige Wärmedämmung an der Unterseite der Heizkammer erfordert. Dennoch arbeitet die Gießvorrichtung qualitativ besser, weil beim Eintauchen der Gießform in die Kühlschmelze durch die schwimmende Wärmeisolationsschicht auch bei komplizierten Gußteilen eine allseitige, vollkommene Wärmedämmung erfolgt. Die erfindungsgemäße Vorrichtung erlaubt es, in der gleichen Anlage wahlweise das erfindungsgemäße Verfahren mit der Kühlschmelze und Wärmeisolationsschicht oder konventionelle DS-SC-Verfahren durchzuführen.

Besonders vorteilhaft ist die Gießvorrichtung gestaltet, wenn gemäß einer Weiterbildung der Erfindung die Gießform von oben her auf einem absenkbaren Haltegestell abgestützt ist, welches die Heizkammer von unten her übergreift und zum Eintauchen in den Tiegel mit der Kühlschmelze durch Absenken des Haltegestells ausgebildet ist. Durch ein solches Haltegestell wird es möglich, die Heizkammer nach oben hin vollständig zu verschließen, weil von oben her kein die Gießform absenkender Gießformhalter in die Heizkammer greifen muß. Die dank der Erfindung mögliche, völlige Abdichtung der Heizkammer an ihrer Oberseite verhindert wiederum Wärmeverluste.

Konstruktiv besonders einfach gestaltet ist die Gießvorrichtung, wenn der Tiegel mit der Kühlschmelze innerhalb einer höhenverfahrbaren Hubkammer angeordnet ist, welche an ihrer Oberseite das Haltegestell trägt.

Die optische Abdichtung zwischen Kühlschmelze und der Unterseite der Heizkammer kann vor Beginn der gerichteten Erstarrung auf einfache Weise verwirklicht werden, wenn der Tiegel relativ zu dieser Hubkammer ebenfalls höhenverfahrbar angeordnet ist.

Die Höhenverfahrbarkeit des Tiegels relativ zur Hubkammer kann auf verschiedene Weise verwirklicht werden. Eine einfache Ausführungsform besteht darin, daß er auf einem durch einen Schlitz in die Hubkammer greifenden Träger angeordnet ist, welcher mittels einer als Spindeltrieb ausgebildeten Vertikalführung höhenverfahrbar angeordnet ist.

Zur Verwirklichung der Höhenverfahrbarkeit kann man sich eines handelsüblichen Bauteils bedienen, wenn gemäß einer anderen Weiterbildung der Erfindung der Tiegel auf einem Träger eines höhenverfahrbaren Schlittens einer Führungssäule angeordnet ist und der Schlitten mittels eines Seiles einer Seilwinde mit einer außerhalb einer Vakuumkammer der Gießvorrichtung angeordneten Handkurbel höhenverfahrbar angeordnet ist.

Beim Eintauchen der Gießform in den Tiegel mit der Kühlschmelze kommt es bei Tiegeln mit geringem Querschnitt infolge der Verdrängung der Kühlschmelze durch die Gießform zu einem Anstieg des Füllstandes, so daß Kühlschmelze unzulässig weit in die Heizkammer gelangen kann. Das läßt sich gemäß einer besonders vorteilhaften Weiterbildung der Erfindung auf einfache Weise dadurch vermeiden, daß der Tiegel für die Kühlschmelze eine durch einen den maximalen Füllstand festlegenden Überlauf von dem Tiegelteil mit der Kühlschmelze abgetrennten Seitenraum aufweist.

Die Erfindung läßt zahlreiche Ausführungsformen zu. Zur weiteren Verdeutlichung ihres Grundprinzips sind zwei davon und eine Abwandlung eines Tiegels für die Kühlschmelze in der Zeichnung dargestellt und werden nachfolgend beschrieben. Diese zeigt in
- Fig.1: einen schematischen Längsschnitt durch eine Gießvorrichtung nach der Erfindung mit einer in eine Heizkammer eingefahrenen Gießform,
- Fig.2: einen der Fig.1 entsprechenden Schnitt mit teilweise aus der Heizkammer in eine Kühlschmelze gefahrene Gießform,
- Fig.3: einen Längsschnitt durch eine zweite Ausführungsform der Gießvorrichtung
- Fig.4: einen Längschnitt durch eine zweite Ausführungsform eines Tiegels für die Kühlschmelze.

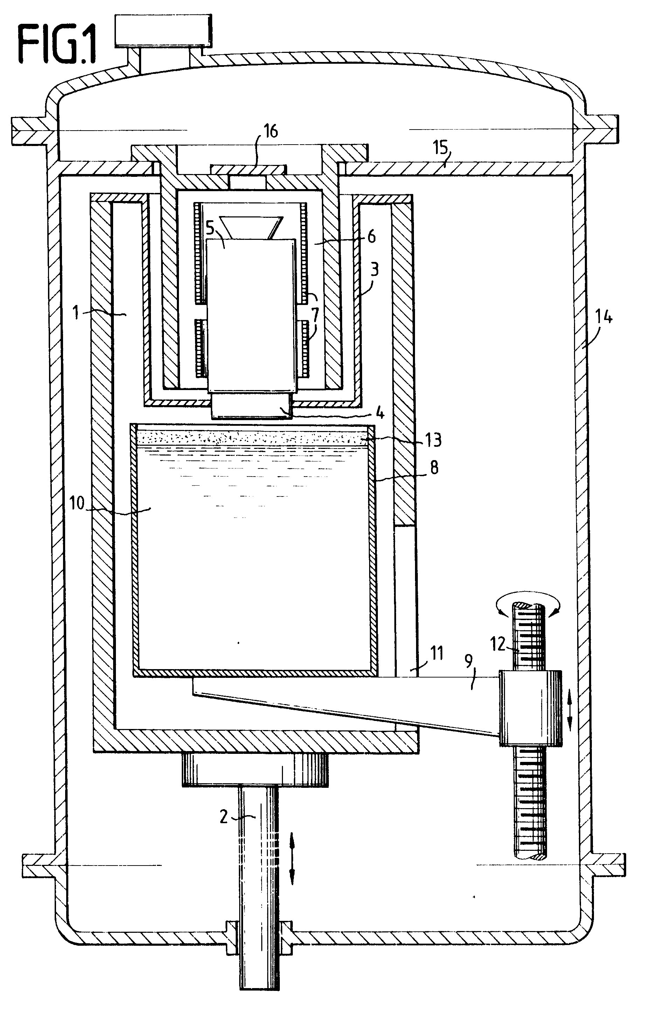

Die Figur 1 zeigt eine Hubkammer 1, welche auf einem Stempel 2 angeordnet ist und durch Verfahren des Stempels 2 nach oben oder unten bewegt werden kann. Von oben her ragt ein auf der Hubkammer 1 abgestütztes Haltegestell 3 in die Hubkammer 1 hinein, bei dem es sich um ein korbartiges Gebilde aus Graphit handeln kann. Auf diesem Haltegestell 3 ist eine Kühlplatte 4 abgestützt, die den Boden einer Gießform 5 bildet. In der dargestellten Gießposition ist die Gießform 5 vollständig in eine Heizkammer 6 eingefahren, welche elektrische Heizelemente 7 enthält, die die Gießform 5 ringförmig umgeben.

Unterhalb der Heizkammer 6 ist ein Tiegel 8 auf einem Träger 9 angeordnet, welcher eine Kühlschmelze 10 enthält. Der Träger 9 führt durch einen Schlitz 11 der Hubkammer 1 nach außen und ist auf einer als Spindeltrieb ausgebildeten Vertikalführung 12 höhenverfahrbar. Wichtig für die Erfindung ist eine beispielsweise aus Aluminiumoxid in Pulver- oder Granulatform bestehende Wärmeisolationsschicht 13, welche auf der Kühlschmelze 10 schwimmt.

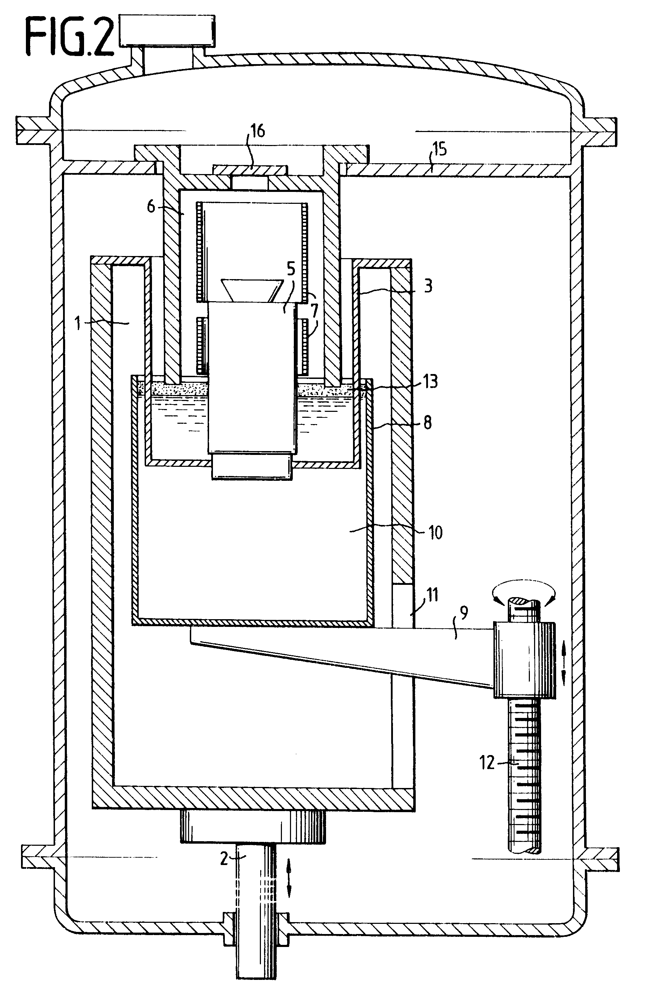

Wenn die Gießform 5 mit flüssigem Metall gefüllt ist und man mit der gerichteten Erstarrung beginnen will, dann fährt man zunächst durch Hochfahren des Trägers 9 auf der Vertikalführung 12 den Tiegel 8 mit der Kühlschmelze 10 so weit nach oben, bis die Unterkante der Heizkammer 6 geringfügig in die Wärmeisolationsschicht 13 eintaucht, so daß eine optische Trennung zwischen dem Inneren der Heizkammer 6, also dem Heizraum und dem Kühlraum, also der Kühlschmelze 10, entsteht. Anschließend beginnt man damit, den Stempel 2 abwärts zu bewegen. Dadurch senkt sich die Hubkammer 1 mit dem Haltegestell 3 ab, so daß die Gießform 5 zunehmend die Wärmeisolationsschicht 13 durchdringt und in die Kühlschmelze 10 eintaucht, was in Figur 2 dargestellt ist. Diese Abwärtsbewegung der Hubkammer 1 setzt man so lange fort, bis die Gießform 5 vollständig in die Kühlschmelze 10 eingetaucht und das Gußteil in ihr dadurch erstarrt ist.

In den Figuren 1 und 2 ist zusätzlich gezeigt, daß die gesamte Gießvorrichtung auf übliche Weise in einer Vakuumkammer 14 angeordnet ist. Diese hat einen nach innen gerichteten, flanschartigen Bund 15, auf der die Heizkammer 6 abgestützt ist. Nicht gezeigt ist ein in der Vakuumkammer 14 angeordneter, schwenkbarer Tiegel, aus dem die Metallschmelze nach Öffnen eines Deckels 16 in die Gießform 5 gegossen werden kann.

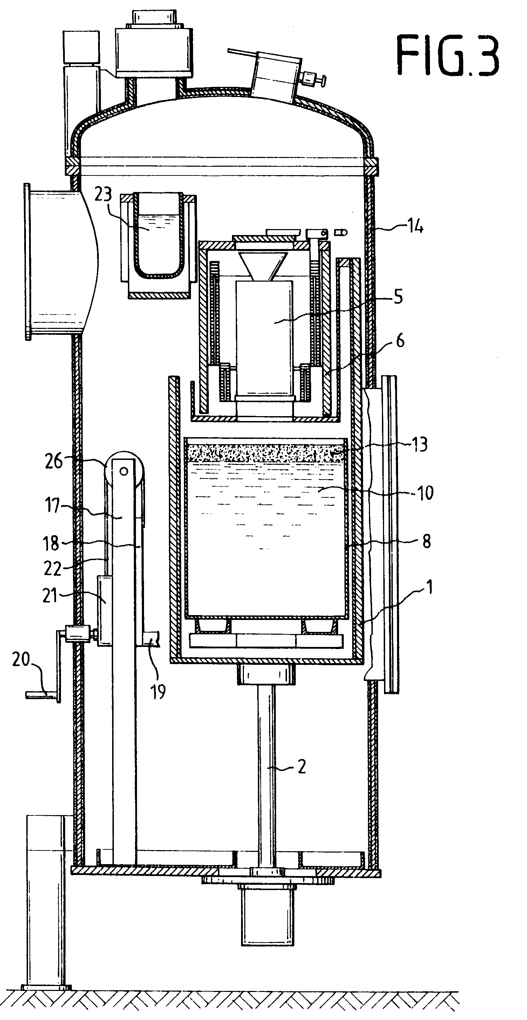

Bei der Ausführungsform nach Figur 3 ist in der Vakuumkammer 14 eine senkrecht stehende Führungssäule 17 angeordnet, auf der ein Schlitten 18 höhenverfahrbar geführt ist. Der Schlitten 18 hat einen abgebrochen dargestellten Träger 19, auf dem der Tiegel 8 steht. Zum Höhenverfahren des Schlittens 18 dient eine Handkurbel 20, mit der eine Seilwinde 21 betätigbar ist, von der ein Seil 22 über eine obere Umlenkrolle 26 der Führungssäule 17 zum Schlitten 18 führt. Diese Anordnung ermöglicht es, vor dem Absenken der Gießform 5 den Tiegel 8 mit der Handkurbel 20 so weit anzuheben, daß die Wärmeisolationsschicht 13 die Unterseite der Heizkammer 6 berührt und damit eine optische Abdichtung herbeiführt.

Zusätzlich zu den Figuren 1 und 2 ist in Figur 3 innerhalb der Vakuumkammer 14 ein schwenkbarer Tiegel 23 dargestellt, welcher zum Einfüllen der Metallschmelze in die Gießform 5 dient. Die Hubkammer 1 wird genau wie bei dem zuvor beschriebenen Ausführungsbeispiel mittels des Stempels 2 höhenverfahren.

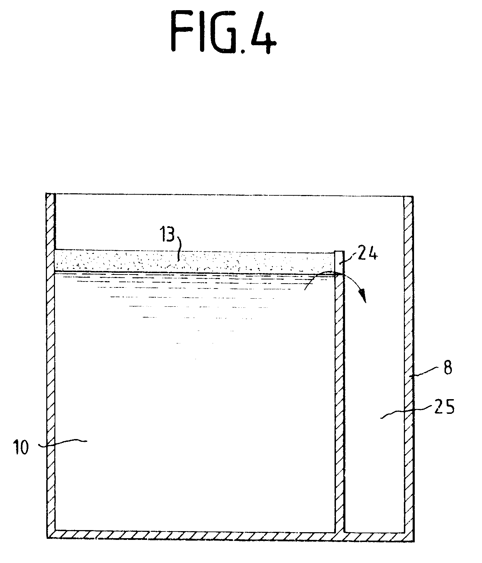

Der in der Figur 4 gezeigte Tiegel 8 unterscheidet sich von dem nach den vorangehenden Figuren dadurch, daß er einen Seitenraum 25 hat, in dem bei einem Absenken der Gießform in die Kühlschmelze 10 die verdrängte Kühlschmelze über einen Überlauf 24 gelangen kann. Nach Beendigung des erfindungsgemäßen Verfahrens kann man die in diesem Seitenraum 25 erstarrte Kühlschmelze aus ihm herausziehen und zurück in den Tiegelteil geben, der für das Abkühlen der Gießform bestimmt ist.

### Bezugszeichenliste

- 1: Hubkammer
- 2: Stempel
- 3: Haltegestell
- 4: Kühlplatte
- 5: Gießform
- 6: Heizkammer
- 7: Heizelement
- 8: Tiegel
- 9: Träger
- 10: Kühlschmelze
- 11: Schlitz
- 12: Vertikalführung
- 13: Wärmeisolationsschicht
- 14: Vakuumkammer
- 15: Bund
- 16: Deckel
- 17: Führungssäule
- 18: Schlitten
- 19: Träger
- 20: Handkurbel
- 21: Seilwinde
- 22: Seil
- 23: Tiegel
- 24: Überlauf
- 25: Seitenraum
- 26: Umlenkrolle

## Patentansprüche

1. Verfahren zum gerichteten Erstarren einer in eine Gießform gegossenen Metallschmelze, beispielsweise Nickel, durch Herausbewegen der Gießform aus einer Heizkammer und Eintauchen der Gießform in ein als Kühlschmelze dienendes Flüssigmetallbad niedrigeren Schmelzpunktes als die Metallschmelze in der Gießform, beispielsweise Aluminium, **dadurch gekennzeichnet**, daß zur Abdichtung zwischen der Heizkammer und der Gießform auf der Kühlschmelze eine schwimmende, aus einem fließfähigen Material bestehende Wärmeisolationsschicht aufgegeben und bevor die Gießform die Wärmeisolationsschicht durchdringt und in die Kühlschmelze eintaucht die Heizkammer oder die Kühlschmelze so weit verfahren wird, daß die Heizkammer die Wärmeisolationsschicht berührt oder in sie eintaucht.

2. Verfahren nach Anspruch 1, **dadurch gekennzeichnet**, daß zur Bildung der Wärmeisolationsschicht Festkörper mit einer von der Kühlschmelze nicht benetzbaren Oberfläche verwendet werden.

3. Verfahren nach Anspruch 2, **dadurch gekennzeichnet**, daß zur Bildung der Wärmeisolationsschicht ein Granulat aus Graphit, Keramik oder Aluminiumoxid mit einer eine Benetzung ausschließenden Beschichtung verwendet wird.

4. Verfahren nach Anspruch 3, **dadurch gekennzeichnet**, daß als Beschichtung Bornitrit verwendet wird.

5. Verfahren nach Anspruch 2, **dadurch gekennzeichnet**, daß unbeschichtete Festkörper aus Bornitrit verwendet werden.

6. Verfahren nach Anspruch 2, **dadurch gekennzeichnet**, daß als Festkörper Kugeln aus SiAlO₂N verwendet werden.

7. Verfahren nach zumindest einem der vorangehenden Ansprüche, **dadurch gekennzeichnet**, daß zur Beeinflussung der metallurgischen Eigenschaften der Gußstücke die Dicke der Wärmeisolationsschicht verändert wird.

8. Verfahren nach zumindest einem der vorangehenden Ansprüche, **dadurch gekennzeichnet**, daß eine Gießform ohne Kühlplatte verwendet wird.

9. Gießvorrichtung zur Durchführung des Verfahrens nach zumindest einem der vorangehenden Ansprüche, welche innerhalb einer Heizkammer (6) eine aus dieser heraus in einen unterhalb von ihr angeordneten Tiegel (8) mit einer Kühlschmelze (10) verfahrbare Gießform (5) hat, wobei an der Unterseite der Heizkammer (6) eine einen Wärmeverlust zwischen der Gießform (5) und der Heizkammer (6) begrenzende Wärmedämmung vorgesehen ist, **dadurch gekennzeichnet**, daß die Wärmedämmung eine auf der Kühlschmelze (10) schwimmende Wärmeisolationsschicht (13) aus einem fließfähigen Material ist, welche zumindest bis zur Unterkante der Heizkammer ragt.

10. Gießvorrichtung nach Anspruch 5, **dadurch gekennzeichnet**, daß die Gießform (5) von oben her auf einem absenkbaren Haltegestell (3) abgestützt ist, welches die Heizkammer (6) von unten her übergreift und zum Eintauchen in den Tiegel (8) mit der Kühlschmelze (10) durch Absenken des Haltegestells (3) ausgebildet ist.

11. Gießvorrichtung nach Anspruch 10, **dadurch gekennzeichnet**, daß der Tiegel (8) mit der Kühlschmelze (10) innerhalb einer höhenverfahrbaren Hubkammer (1) angeordnet ist, welche an ihrer Oberseite das Haltegestell (3) trägt.

12. Gießvorrichtung nach Anspruch 11, **dadurch gekennzeichnet**, daß der Tiegel (8) relativ zur dieser Hubkammer (1) ebenfalls höhenverfahrbar angeordnet ist.

13. Gießvorrichtung nach Anspruch 12, **dadurch gekennzeichnet**, daß der Tiegel (8) auf einem durch einen Schlitz (11) in die Hubkammer (1) greifenden Träger (9) angeordnet ist, welcher mittels einer als Spindeltrieb ausgebildeten Vertikalführung (12) höhenverfahrbar angeordnet ist.

14. Gießvorrichtung nach Anspruch 12, **dadurch gekennzeichnet,** daß der Tiegel (8) auf einem Träger (19) eines höhenverfahrbaren Schlittens (18) einer Führungssäule (17) angeordnet ist und der Schlitten (18) mittels eines Seiles (22) einer Seilwinde (21) mit einer außerhalb einer Vakuumkammer (14) der Gießvorrichtung angeordneten Handkurbel (20) höhenverfahrbar angeordnet ist.

15. Gießvorrichtung nach Anspruch 9 oder einem der diesem folgenden, **dadurch gekennzeichnet**, daß der Tiegel (8) für die Kühlschmelze (10) eine durch einen den maximalen Füllstand festlegenden Überlauf (24) von dem Tiegelteil mit der Kühlschmelze (10) abgetrennten Seitenraum (25) aufweist.

## Claims

1. A method for directional solidification of a molten metal, for example nickel, poured into a mould, by moving the mould out of a heating chamber and immersing the mould in a liquid metal bath serving as a quenching melt, for example aluminium, and having a lower melting point than the molten metal in the mould, characterised in that a floating heat-insulating layer consisting of a material capable of flowing is placed on the quenching melt to provide a seal between the heating chamber and the mould and, before the mould penetrates the heat-insulating layer and dips into the quenching melt, the heating chamber or the quenching melt is moved to the extent that the heating chamber touches the heat-insulating layer or dips into it.

2. A method according to claim 1, characterised in that solids are used to form the heat-insulating layer which have a surface which is not wettable by the quenching melt.

3. A method according to claim 2, characterised in that granules of graphite, ceramics or aluminium oxide with a coating which prevents wetting are used to form the heat-insulating layer.

4. A method according to claim 3, characterised in that boron nitrite is used as the coating.

5. A method according to claim 2, characterised in that uncoated solids of boron nitrite are used.

6. A method according to claim 2, characterised in that beads of SiAlO₂N are used as the solids.

7. A method according to at least one of the preceding claims, characterised in that the metallurgical properties of the castings are influenced by varying the thickness of the heat-insulating layer.

8. A method according to at least one of the preceding claims, characterised in that a mould without a cooling plate is used.

9. A casting apparatus for carrying out the method according to at least one of the preceding claims, comprising, inside a heating chamber (6), a mould (5) which may be displaced out of said heating chamber (6) into a crucible (8) arranged therebelow and containing a quenching melt (10), wherein heat insulation is provided on the bottom of the heating chamber (6) to restrict heat loss between the mould (5) and the heating chamber (6), characterised in that the heat insulation is a heat-insulating layer (13) of a flowable material floating on the quenching melt (10) and extending at least as far as the bottom edge of the heating chamber.

10. A casting apparatus according to claim 5, characterised in that the mould (5) is supported from above on a lowerable holding frame (3) which encloses the heating chamber (6) from below and is designed to be lowered for the purpose of immersion into the crucible (8) containing the quenching melt (10).

11. A casting apparatus according to claim 10, characterised in that the crucible (8) containing the quenching melt (10) is disposed within a vertically displaceable lifting chamber (1), which carries the holding frame (3) at its top.

12. A casting apparatus according to claim 11, characterised in that the crucible (8) is likewise disposed for vertical movement relative to this lifting chamber (1).

13. A casting apparatus according to claim 12, characterised in that the crucible (8) is arranged on a beam (9) extending through a slot (11) into the lifting chamber (1), which beam (9) is arranged so as to be vertically displaceable by means of a vertical guide (12) constructed as a spindle drive.

14. A casting apparatus according to claim 12, characterised in that the crucible (8) is disposed on a beam (19) of a vertically displaceable carriage (18) on a guide column (17) and the carriage (18) is arranged so as to be vertically displaceable by means of the cable (22) of a cable winch (21) having a crank handle (20) disposed outside a vacuum chamber (14) of the casting apparatus.

15. A casting apparatus according to claim 9 or one of the subsequent claims, characterised in that the crucible (8) for the quenching melt (10) has a side chamber (25) separated from the crucible part containing the quenching melt (10) by a spillway (24) determining the maximum filling level.

## Revendications

1. Procédé pour la solidification dirigée d'un métal en fusion, par exemple du nickel, coulé dans un moule de fonderie par extraction du moule hors d'une chambre de chauffe et par plongée du moule dans un bain de métal liquide servant de fonte de refroidissement avec un point de fusion inférieur à celui du métal en fusion dans le moule, par exemple de l'aluminium, caractérisé en ce que pour l'étanchement entre la chambre de chauffe et le moule, on dépose une couche calorifuge flottante sur la fonte de refroidissement et constituée en un matériau fluide, et en ce qu'avant que le moule traverse la couche calorifuge et plonge dans la fonte de refroidissement, on déplace la chambre de chauffe ou la fonte de refroidissement aussi loin que la chambre de chauffe touche la couche calorifuge ou plonge dans celle-ci.

2. Procédé selon la revendication 1, caractérisé en ce que pour former la couche calorifuge, on utilise des corps solides qui présentent une surface qui n'est pas mouillable par la fonte de refroidissement.

3. Procédé selon la revendication 2, caractérisé en ce que pour former la couche calorifuge, on utilise des granulés en graphite, en céramique ou en oxyde d'aluminium comportant un revêtement qui exclut un mouillage.

4. Procédé selon la revendication 3, caractérisé en ce que l'on utilise en tant que revêtement du nitrite de bore.

5. Procédé selon la revendication 2, caractérisé en ce que l'on utilise des corps solides en nitrite de bore non revêtus.

6. Procédé selon la revendication 2, caractérisé en ce que l'on utilise en tant que corps solides des billes en SiAlO₂N.

7. Procédé selon l'une au moins des revendications précédentes, caractérisé en ce que pour influencer les propriétés métallurgiques des pièces coulées, on modifie l'épaisseur de la couche calorifuge.

8. Procédé selon l'une au moins des revendications précédentes, caractérisé en ce que l'on utilise un moule sans plaque de refroidissement.

9. Dispositif de coulée pour mettre en oeuvre le procédé selon l'une au moins des revendications précédentes, qui possède à l'intérieur d'une chambre de chauffe (6) un moule (5) mobile hors de celle-ci jusque dans un creuset (8) contenant une fonte de refroidissement (10) et agencé au-dessous de ladite chambre, une isolation thermique qui limite des pertes de chaleur entre le moule (5) et la chambre de chauffe (6) étant prévue sur la face inférieure de la chambre de chauffe (6), caractérisé en ce que l'isolation thermique est une couche calorifuge (13) flottant sur la fonte de refroidissement (10) et constituée en un matériau fluide, qui s'étend au moins jusqu'au bord inférieur de la chambre de chauffe.

10. Dispositif de coulée selon la revendication 5, caractérisé en ce que le moule (5) est appuyé depuis le haut sur un bâti de maintien (3) susceptible d'être abaissé qui, venant de dessous, s'étend au-dessus de la chambre de chauffe (6), et en ce qu'il est réalisé de manière à plonger dans le creuset (8) contenant la fonte de refroidissement (10) par abaissement du bâti de maintien (3).

11. Dispositif de coulée selon la revendication 10, caractérisé en ce que le creuset (8) contenant la fonte de refroidissement (10) est agencé à l'intérieur d'une chambre mobile en hauteur (1) qui porte sur sa face supérieure le bâti de maintien (3).

12. Dispositif de coulé selon la revendication 11, caractérisé en ce que le creuset (8) est également agencé de façon mobile en hauteur par rapport à cette chambre mobile (1).

13. Dispositif de coulée selon la revendication 12, caractérisé en ce que le creuset (8) est agencé sur un support (9) qui s'engage à travers une fente (11) dans la chambre mobile (1) et qui est agencé de manière mobile en hauteur au moyen d'un guidage vertical (12) réalisé sous forme d'un entraînement à broche.

14. Dispositif de coulée selon la revendication 12, caractérisé en ce que le creuset (8) est agencé sur un support (19) d'un chariot mobile en hauteur (18) d'une colonne de guidage (17), et en ce que le chariot (18) est agencé de façon mobile en hauteur au moyen d'un câble (22) d'un treuil (21) comportant une manivelle à main (20) agencée à l'extérieur d'une chambre sous vide (14) du dispositif de coulée.

15. Dispositif de coulée selon la revendication 9 ou selon l'une quelconque de celles qui la suivent, caractérisé en ce que le creuset (8) présente pour la fonte de refroidissement (19) une chambre latérale (25) séparée de la partie de creuset contenant la fonte de refroidissement (10) par un trop-plein (24) déterminant le niveau de remplissage maximal.
